**Europäisches Patentamt**

**European Patent Office**

**Office européen des brevets**

(19)

(11) Veröffentlichungsnummer: **0 165 434**
**B1**

(12) # EUROPÄISCHE PATENTSCHRIFT

(45) Veröffentlichungstag der Patentschrift:
18.05.88

(51) Int. Cl.⁴: **H 05 K 7/14**

(21) Anmeldenummer: **85105651.5**

(22) Anmeldetag: **08.05.85**

(54) Kastenförmige Flachbaugruppe.

(30) Priorität: 21.05.84 DE 3418844

(43) Veröffentlichungstag der Anmeldung:
27.12.85 Patentblatt 85/52

(45) Bekanntmachung des Hinweises auf die Patenterteilung:
18.05.88 Patentblatt 88/20

(84) Benannte Vertragsstaaten:
AT BE CH DE FR GB IT LI SE

(56) Entgegenhaltungen:
DE-A-3 014 234
US-A-4 151 580

(73) Patentinhaber: **Siemens Aktiengesellschaft Berlin und München, Wittelsbacherplatz 2, D-8000 München 2 (DE)**

(72) Erfinder: **Deinhardt, Günther, Dipl.- Ing., Von- der- Sitt- Strasse 13a, D-8450 Amberg (DE)**
Erfinder: **Münch, Heinz- Dieter, Dipl.- Ing., Seb.- Regler- Strasse 49, D-8450 Amberg (DE)**
Erfinder: **Meusel, Otto, Aufsessstrasse 18, D-8520 Erlangen (DE)**
Erfinder: **Seidel, Siegfried, Dipl.- Ing., Friedlandstrasse 36, D-8450 Amberg (DE)**

EP 0 165 434 B1

## Beschreibung

Die Erfindung bezieht sich auf eine kastenförmige elektronische Flachbaugruppe mit frontseitig betätigbaren, als Steckeinheit ausgebildeten Schraubanschlüssen für Anschlußleitungen, wobei die Anschlußleitungseinführungsöffnungen der Schraubanschlüsse in einem zur Frontseite hin offenen Längskanal auslaufen und wobei die mit einem Schwenkgelenk versehene Steckeinheit mit einer in der Flachbaugruppe vorgesehenen Leiterplatte kontaktierbar ist.

Aus der US-A-4 151 580 ist eine kastenförmige elektronische Flachbaugruppe der obengenannten Art bekannt. Hier sind Anzeigelampen und Schraubanschlüsse voneinander getrennt angeordnet, so daß keine Zuordnung und keine Beschriftungsmöglichkeit vorhanden ist. Außerdem ist beim Einschwenken eine Relativbewegung zwischen Leiterplatte und Steckeinheit nicht auszuschließen.

Bei einer weiterhin bekannten Baugruppe (DE-OS-2 904 012) sind auf einem Baugruppenträger nach vorn ragende mechanische Kapseln fest montiert, die frontseitig mit Öffnungen zum Einschub der Steckplatten versehen sind. An der linken Frontseite der Kapsel ist seitlich ein Anschlußblock vorgesehen, der eine vielpolige Kontaktleiste mit Schraubanschlüssen zur Aufnahme von Externleitungen umfaßt. Jeder dieser Schraubanschlüsse weist dem Kapselinnern zugewandt Kontaktteile auf, die beim Einschieben der Steckplatte mit entsprechenden, seitlich an der Steckplatte angeordneten Gegenkontakten kontaktieren. Mit der Steckplatte ist hier die Abdeckung fest verbunden. Der Leitungskanal wird durch diese Abdeckung nicht abgedeckt.

Die oben bezeichnete Anordnung soll dahingehend verbessert werden, daß unter Beibehaltung der bequemen Anschlußmöglichkeit von der Frontseite bzw. der Zurverfügungstellung von genügendem Raum zur Beschriftung und für Anzeigezwecke die Flachbaugruppen unmittelbar mit ihren Flachseiten aneinandergrenzend nebeneinander auf einem Träger platzsparend angeordnet werden können und unter Beibehaltung der bequemen Anschlußmöglichkeit in Form von Steckanschlüssen auch eine genaue und sichere Steckverbindung unter Ausschaltung einer Relativbewegung zwischen Leiterplatte und Steckeinheit über Zwischenteile ohne erheblichen Aufwand gewährleistet ist. Dies wird dadurch erreicht, daß eine als Beschriftungsplatte ausgebildete Abdeckung den Längskanal und die Schraubanschlüsse an der Frontseite der Flachbaugruppe abdeckt und eine der Steckeinheit angepaßte Steckerleiste mit der Leiterplatte elektrisch und mechanisch verbunden ist und daß die Steckeinheit mit einem Schwenkgelenk versehen ist, dessen Gegenlager an der Steckerleiste angebracht ist. Anstelle einer Vorraststellung hat es sich als vorteilhaft erwiesen, wenn der Längskanal an der Steckeinheit vorgesehen ist und die den Schraubanschlüssen gegenüberliegende Seitenwand abnehmbar ausgebildet ist. Die freie Zugänglichkeit für das Einbringen der Leitungen bleibt hierdurch erhalten. Beim Stand der Technik - US-PS-3 992 654 - ist hier eine gesonderte Kappe abzunehmen, wobei die Zugänglichkeit für die Schraubanschlüsse durch den Befestigungswinkel für die Kappe beeinträchtigt wird. Um das Einbringen und Herausziehen der Steuereinheit zu erleichtern ist es vorteilhaft, wenn an der dem Schwenkgelenk gegenüberliegenden Seite der Steuereinheit eine axial unverschieblich gelagerte, in ein Gewinde an der Steckerleiste eindrehbare Befestigungsschraube angeordnet ist. Eine sichere Zuordnung der Bezeichnung für die Lumineszenzdioden auf der Beschriftungsplatte läßt sich erreichen, wenn der Längskanal auf der einen Seite von den Schraubanschlüssen und danebenliegenden Lumineszenzdioden flankiert ist, wobei die Beschriftungsplatte im Betriebszustand direkt neben den Lumineszenzdioden liegt. Da die Lumineszenzdioden mehr oder weniger auf gleicher Höhe wie die Schraubanschlüsse liegen sollen, die Leiterplatte jedoch erst hinter den Schraubanschlüssen beginnen kann, ist es vorteilhaft, wenn die Lumineszenzdioden in einem mit der Leiterplatte elektrisch und mechanisch verbundenen Halter angeordnet sind. Um sicherzustellen, daß Einstellungen oder Prüfungen nur vom Fachpersonal bzw. nur im spannungsfreien Zustand der Flachbaugruppen durchgeführt werden, hat es sich als vorteilhaft erwiesen, wenn von der Frontseite gesehen hinter der Steckeinheit nach Ausschwenken der Steckeinheit von der Frontseite zugänglich Module zur Absicherung und/oder Einstellung von Arbeits- und Meßbereichen in der Flach baugruppe befestigt sind.

Um die auf die Module aufbringbaren äußeren Belastungen, beispielsweise beim Auswechseln von Sicherungen von der Leiterplatte fernzuhalten ist es weiterhin vorteilhaft, wenn die Module über ihre Seitenwandung mit Schwalbenschwanzverbindung mit der Steckerleiste in Verbindung stehen und gegen Anschläge gedrückt werden.

Anhand der Zeichnung wird ein Ausführungsbeispiel gemäß der Erfindung beschrieben und die Wirkungsweise näher erläutert.

Es zeigen:

Fig. 1 zwei Flachbaugruppen in Seitenansicht, zum Teil im Schnitt,

Fig. 2 den Bereich der Klemmleiste im ausgefahrenen Zustand der Klemmleiste, ebenfalls teilweise im Schnitt,

Fig. 3 die Anordnung nach Fig. 2 im eingeschobenen Zustand der Klemmleiste,

Fig. 4 die um 90° versetzte Darstellung der Anordnung nach Fig. 3,

Fig. 5 eine Draufsicht auf die mit der Flachbaugruppe verbundene Beschriftungsplatte,

Fig. 6 eine perspektivische Darstellung einer weiteren Flachbaugruppe und

Fig. 7 eine Einzelteilzeichnung im Bereich der Verbindung zwischen Steckerleiste und Leiterplatte sowie den angesetzten Modulen und der LED-Anzeigen.

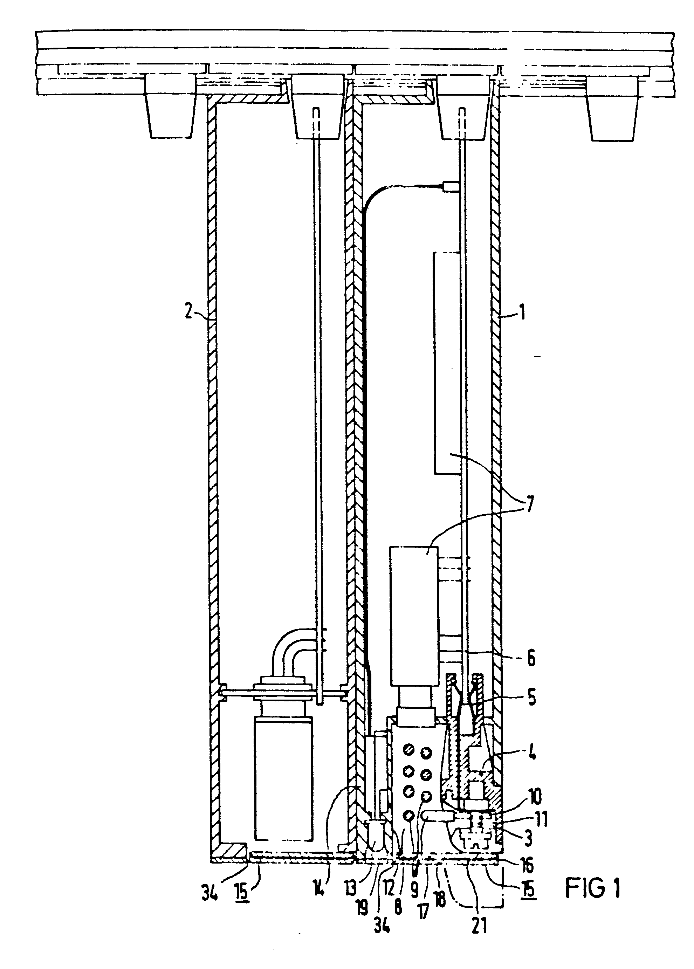

Von den aus Fig. 1 ersichtlichen Flachbaugruppen 1 und 2 ist die Flachbaugruppe 1 mit den Schraubanschlüssen 3 versehen, die mit einer Steckeinheit 4 zusammengefaßt sind und mit den Kontaktfedern 5 Anschlüsse an der Leiterplatte 6 kontaktieren. Auf der Leiterplatte 6 sind die elektronischen Bauteile 7 befestigt. Die Leiterplatte 6 ist in üblicher Weise in der Flachbaugruppe gehalten und auf der der Frontseite gegenüberliegenden Seite ebenfalls mit weiteren Steckanschlüssen zur internen Verdrahtung mehrerer Flachbaugruppen untereinander versehen. Den Schraubanschlüssen 3 benachbart ist ein Kanal 8, in dem die Leitungen 9 geführt werden können, deren Enden 10 abisoliert in die Anschlußleitungseinführungsöffnungen 11 zum Anklemmen an den Schraubanschlüssen eingeschoben sind. Der Kanal 8 wird auf der gegenüberliegenden Seite von der Wand 12 begrenzt, hinter der sich die Lumineszenzdioden 13 befinden, die entsprechend verdrahtet als Anzeigemittel für den Schaltzustand der Flachbaugruppen dienen. Sie können mit der Leiterplatte 6 gemeinsam zu einer einlegbaren Baueinheit zusammengefaßt sein und auf der Leiterplatte verdrahtet werden, so daß die Lumineszenzdioden 13 an der Außenwand 14 des kastenförmigen Gehäuses der Flachbaugruppe 1 liegen. Abgedeckt wird die Flachbaugruppe 1 von einer Beschriftungsplatte 15, die aus über das Filmscharnier 16 verbundenen zwei Platten 17 und 18 zusammengeklappt ist und über Schnappverbindung mit dem kastenförmigen Gehäuse der Flachbaugruppe in verbindung gebracht ist. Die einteilige Beschriftungsplatte 15 kann als schwenkbare Tür ausgeführt werden, die zwei Filmscharniere hat: Eines zum Öffnen zwecks Einlegen des Beschriftungsschildes und eines zum Ausschwenken des Klappenteils, um an den vertikalen Kabelschacht zu gelangen. Die komplette Beschriftungsplatte 15 kann beim Auswechseln der Baugruppe entfernt und an der neuen Baugruppe mit dem linken Beschriftungsplatten-Streifen wieder eingeschnappt werden. Damit entfällt eine erneute Beschriftung. Die Tür wird nach dem Schließen mit dem Frontstecker verrastet. Auch auf der Innenseite der Beschriftungsplatte können Beschriftungen angebracht werden, falls erforderlich.

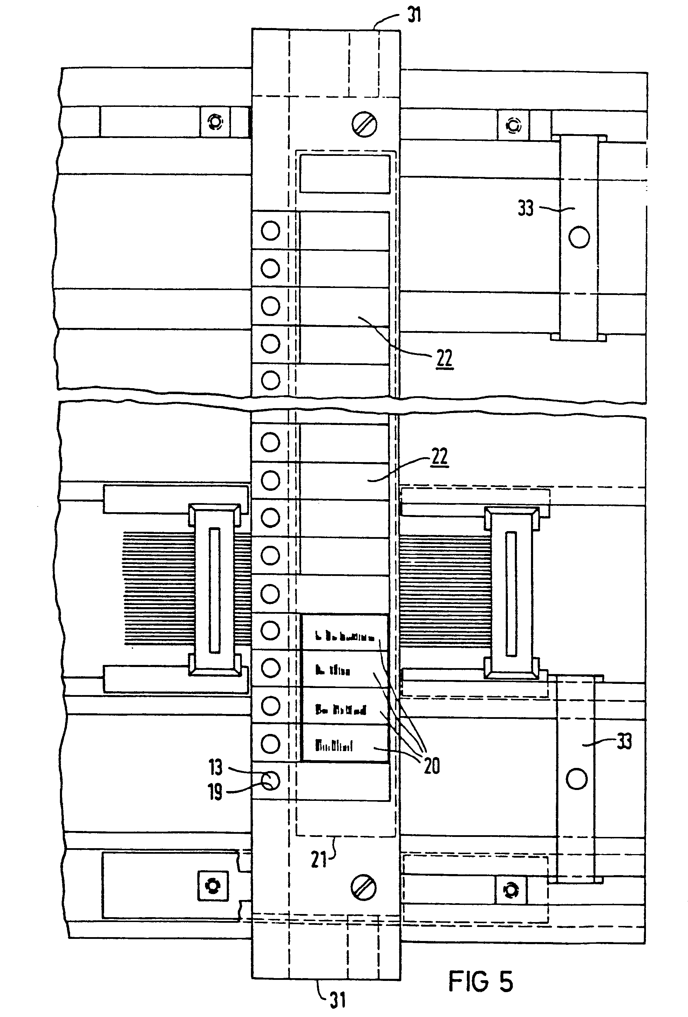

Wie die Fig. 5 zeigt, sind in beiden Platten 17 und 18 Durchbrechungen 19 vorhanden, durch die die Lumineszenzdioden 13 erkennbar sind. Weiterhin sind Beschriftungsfelder 20 für ein zwischen den beiden Platten 17 und 18 eingeklemmtes Beschriftungsblatt 21 vorhanden. Diese Beschriftungsfelder können als Ausnehmung 22 aus der Platte 18 bestehen. Die Platte 18 kann auch durchsichtig gestaltet werden, so daß die Beschriftung auf dem Beschriftungsblatt durch die Platte 18 hindurchgesehen werden kann. Das vorsehen der Ausnehmung 22 hat den Vorteil, daß die Flachbaugruppe ohne Öfnung der Platte 18 von außen von Hand beschriftet werden kann. Die Flachbaugruppe 2 enthält keine Schraubanschlüsse 3, sondern wird nur über die vorbeschriebene interne Verdrahtung konraktiert, so daß die Seschriftungsplatte 15 ohne Beschriftungsfelder und Durchbrechungen 19 für die Lumineszenzdioden ausgeführt werden kann.

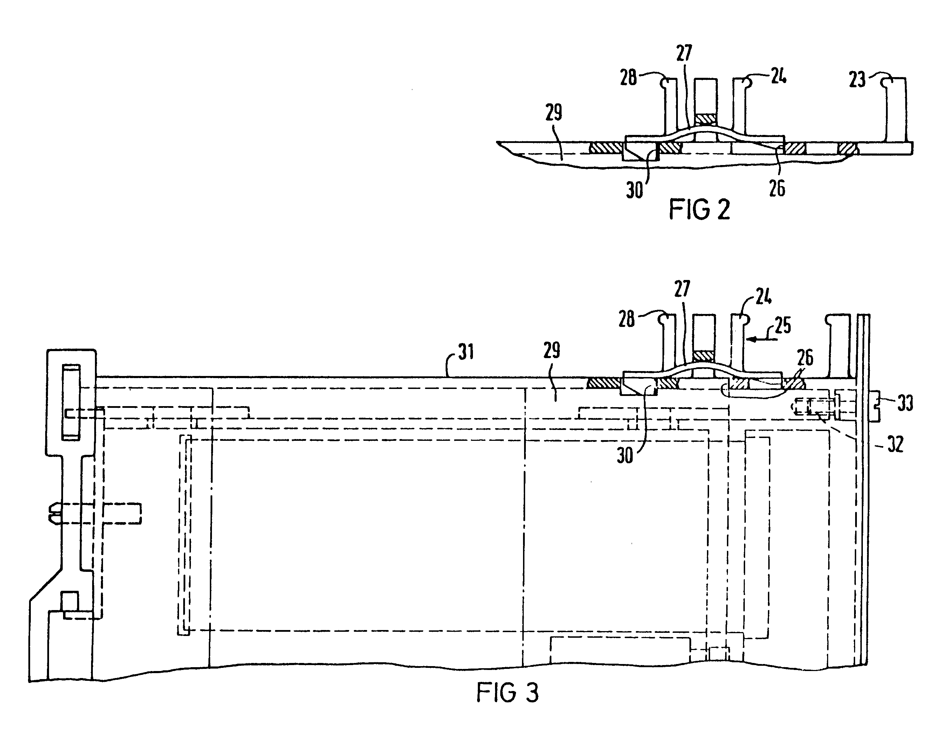

Um das Einführen der Enden 10 in die Anschlußleitungseinführungsöffnungen 11 zu erleichtern, ist die Steckeinheit 4 in die aus Fig. 1 gestrichelt ersichtliche Lage führbar und in dieser Lage verrastbar. Hierzu können an den schmalen Seitenflächen mit der Steckeinheit 4 verbundene Handhaben 23 dienen (wie dies aus Fig. 2 und 3 zu ersehen ist). Soll die Steckeinheit aus der aus Fig. 2 ersichtlichen Vorverdrahtungsstellung in die aus Fig. 3 ersichtliche gebracht werden, so kann durch Druck auf einen Rasthebel 24 in Richtung des Pfeiles 25 die Verrastung 26 aufgehoben werden und die Steckeinheit 4 mittels Handhaben 23 zur Kontaktierung der Kontaktfedern 4 mit den Anschlüssen der Leiterplatte 6 eingeschoben werden. Der Rasthebel 24 kann an einem Rastteil 27 angeformt sein, das mit einem der stangenförmigen Führungsteile 29 über die Rastverbindung 30 verrastet ist. Uber einen Entrastungsvorsprung 28 kann die Rastverbindung aufgehoben werden. Die stangenförmigen Führungsteile 29 sind beispielsweise an den beiden schmalen Stirnseiten 31 der Flachbaugruppen vorgesehen und mit Gewinden 32 ausgestattet, in die Befestigungsschrauben für die Beschriftungsplatten 15 eingebracht sind. Bei metallischen Führungsstangen können diese auch zu Abschirmzwecken herangezogen werden, z. B. durch Masse-Kontaktierung der LP-Schirmflächen über an den Führungsstangen angenietete Schleifkontaktfedern. Die Führungsstangen können bei entfernter Baugruppe zum Fixieren der Frontstecker benutzt werden, damit diese nicht frei an den Kabeln herunterhängen. Die Positionierung und Zuordnung der stangenförmigen Führungsteile und Buskabel-Steckplätze kann z. B. über nur seitlich einschnappbare Anschläge 33 bewirkt werden.

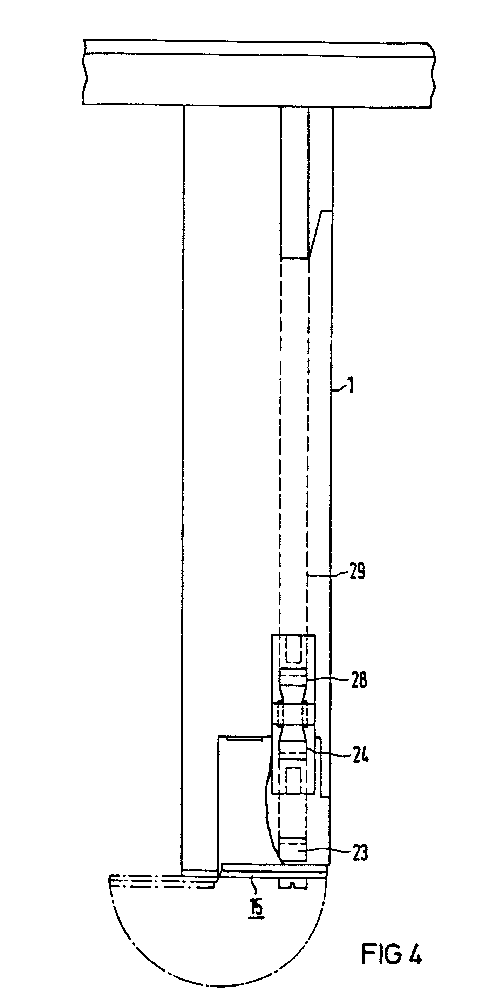

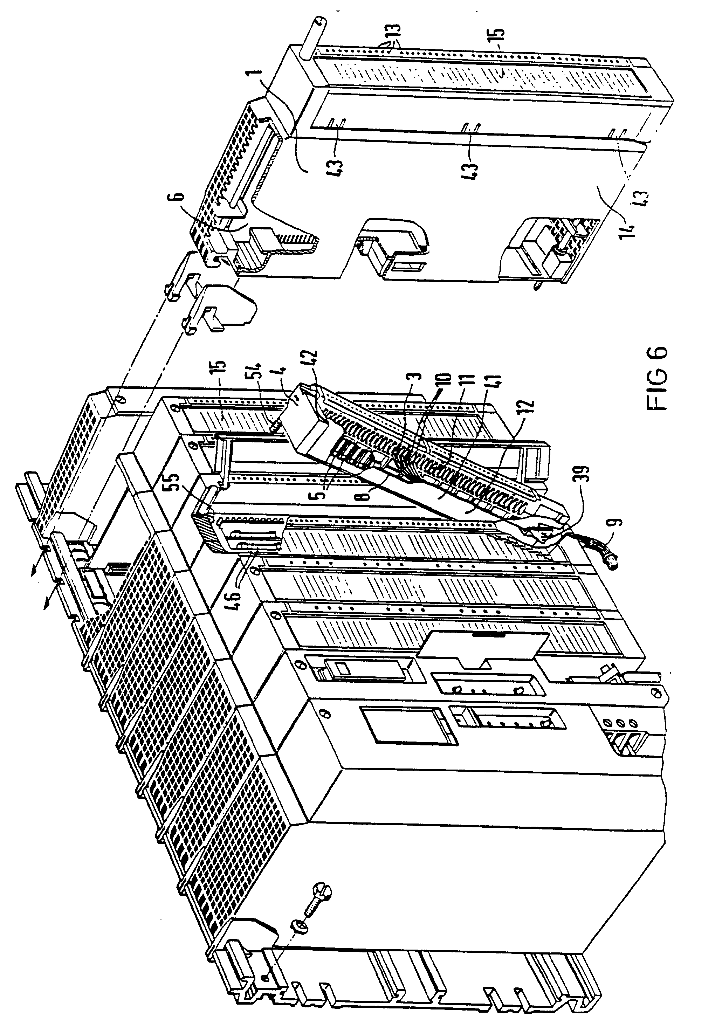

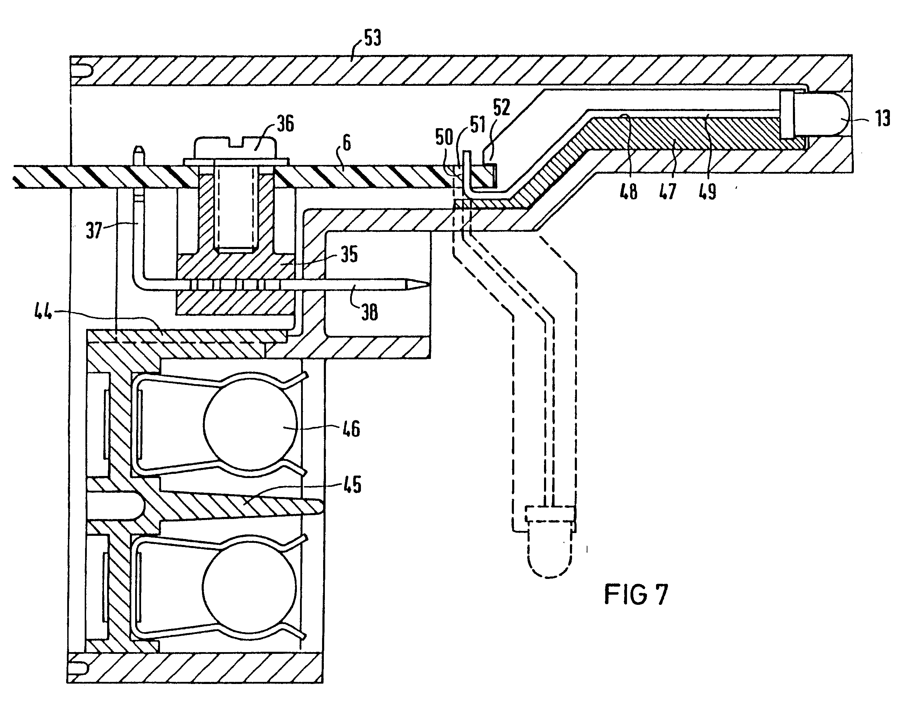

Im Ausführungsbeispiel nach Fig. 6 und 7 ist an der der Steckeinheit 4 zugewandten Seite der Leiterplatte 6 eine Messerleiste 35 vorgesehen, die mit der Leiterplatte 6 - wie Fig. 7 zeigt - über Schrauben 36 fest verbunden ist. Die Steckerleiste 35 trägt die mit den Strombahnen der Leiterplatte 6 elektrisch zu verbindenden Anschlußfahnen 37, die in die messerförmigen Steckanschlüsse 38 übergehen. Die Steckanschlüsse 38 wirken mit den Kontaktfedern 5 der Steckeinheit 4 im eingebrachten Zustand der Steckeinheit zusammen. Die Kontaktfedern 5 ihrerseits sind mit den Schraubanschlüssen 3 der Steckeinheit 4 elektrisch leitend verbunden, vorzugsweise aus einem Stanzbiegeteil hergestellt. Im Ausführungsbeispiel nach den Fig. 6 und 7 ist die Steckeinheit 4 mit einem Schwenkgelenk 39 versehen, dessen Gegenlager an der Messerleiste 35 vorhanden ist. Die Steckeinheit 4 läßt sich auf einfache Weise mit der Messerleiste 35 durch Einhaken in Verbindung bringen und somit das Schwenkgelenk herstellen, indem die Steckeinheit 4 in Richtung des Pfeiles verschwenkbar wird. Da die Lagerung an der Messerleiste 35 vorgesehen ist, bleibt die Leiterplatte 6 praktisch ohne mechanische Spannungen, so daß hierdurch gegebenenfalls hervorgerufene Leiterunterbrechungen auf der Leiterplatte 6 vermieden werden. Um auch beim Ausführungsbeispiel nach den Fig. 6 und 7 ein einfaches Einführen der Anschlußleitungen 9 mit den Enden 10 in die Anschlußleitungseinführungsöffnungen 11 durchführen zu können, ist bei der schwenkbaren Steckeinheit 4 die Seitenwand 41 abnehmbar. Sie ist in Nuten 42 des Gehäuses der Steckeinheit 4 eingeschoben und mittels Rastzungen 43 verrastet. Gegenüber dem Ausführungsbeispiel nach Fig. 1 bis 4 kann somit hier auf die Vorraststellung verzichtet werden. Dadurch, daß beim Ausführungsbeispiel nach den Fig. 6 und 7 die Schraubanschlüsse 3 zusammen mit den Lumineszenzdioden 13 auf der einen Seite des Kanales 8 liegen, ist eine direkte Zuordnung von Schraubanschlüssen zu Lumineszenzdioden erkennbar. Bei geöffneter Beschriftungsplatte 15 ist die Innenseite der Beschriftungsplatte auch zu Bezeichnungszwecken verwendbar. Die Beschriftungsplatte 15, die hier mittels Scharnieren schwenkbar an der Flachbaugruppe gehalten ist, deckt die Schraubanschlüsse im eingeschwenkten Zustand der Steckeinheit 4 ab. Mit der Steckerleiste 35 kann über Schwalbenschwanzverbindung 44 ein Modul 45 derart verbunden werden, daß es nach Ausschwenken der Steckeinheit 4 von der Frontseite der Flachbaugruppe 1 zugänglich ist. Im vorliegenden Fall sind beispielsweise Sicherungen 46 dargestellt, die von der Frontseite auswechselbar sind. Anstelle eines Moduls 45 zur Absicherung kann hier auch ein Modul zur Einstellung von Arbeits- oder Meßbereichen eingeschoben werden. Wie die Fig. 7 zeigt, sind die Lumineszenzdioden 13, um Platz für die Steckverbindungen zwischen Steckerleiste und Steckeinheit zu gewinnen, in bezug auf die Leiterplattenebene derart angeordnet, daß sie beim Löten der Leiterplatte in einem Tauchbad in das Tauchbad eintauchen würden. Um hier eine einfache Befestigungsmöglichkeit elektrischer und mechanischer Art zu schaffen, sind die Lumineszenzdioden in einem Halter 47 untergebracht, der mit Nuten 48 zum Einlegen der Anschlußleitungen 49 für die Lumineszenzdioden 13 versehen ist. Die Enden der Anschlußleitungen 49 werden in entsprechende Anschlußöffnungen 50 der Leiterplatte 6 eingeschoben. Der Halter besitzt abbrechbare Zapfen 51, die in entsprechende Ausnehmungen der Leiterplatte 6 eingeschoben werden, ohne hierbei eine elektrische Verbindung herzustellen. Die Lage des Halters 47 ist gestrichelt in Fig. 7 angedeutet. Da die Lumineszenzdioden nunmehr auf der anderen Seite der Leiterplatte 6 liegen, kann die Leiterplatte ohne Schwierigkeiten verzinnt werden und hiermit die Anschlüsse für die Anschlußleitungen 49 hergestellt werden. Hernach brechen die Zapfen 51 beim Umklappen der Lumineszenzdiodenhalter in die Betriebslage selbsttätig ab; die Leitungen 49 können durch entsprechende Schlitze im Halter durchrutschen und der Halter 47 kann sich mit Rastnasen 52 um die Leiterplatte 6 herum verrasten und die aus der Fig. 7 ersichtliche Lage annehmen. Die messerförmigen Steckanschlüsse 38, die Module 45, sowie die Halter 47 und damit die Lumineszenzdioden 13 selbst und auch die Leiterplatten 6 im oberen Bereich werden durch eine Kappe 53 abgedeckt, die Platz für die Steckeinheit 4 übrigläßt. Eine Befestigungsschraube 54 ist an der dem Schwenkgelenk 39 gegenüberliegenden Seite gegen axiale Verschiebung gesichert drehbar gelagert und zum Einschwenken und Herausdrehen der Steckeinheit mit einem Gegengewinde 55 in der Steckerleiste 35 in Eingriff bringbar.

## Patentansprüche

1. Kastenförmige elektronische Flachbaugruppe (1) mit frontseitig betätigbaren, als Steckeinheit (4) ausgebildeten Schraubanschlüssen (3) für Anschlußleitungen (9), wobei die Anschlußleitungseinführungsöffnungen (11) der Schraubanschlüsse (3) in einem zur Frontseite hin offenen Längskanal (8) auslaufen und wobei die mit einem Schwenkgelenk (39) versehene Steckeinheit (4) mit einer in der Flachbaugruppe (1) vorgesehenen Leiterplatte (6) kontaktierbar ist, dadurch gekennzeichnet, daß eine als Beschriftungsplatte (15) ausgebildete Abdeckung den Längskanal (8) und die Schraubanschlüsse (3) an der Frontseite der Flachbaugruppe (1) abdeckt und eine der Steckeinheit (4) angepaßte Steckerleiste (35) mit der Leiterplatte (6) elektrisch und mechanisch verbunden ist und daß die Steckeinheit (4) mit einem Schwenkgelenk (39) versehen ist, dessen Gegenlager an der Steckerleiste (35) angebracht ist.

2. Flachbaugruppe nach Anspruch 1, dadurch gekennzeichne, daß der Längskanal (8) an der Steckeinheit (4) vorgesehen ist und die den Schraubanschlüssen (3) gegenüberliegende Seitenwand (41) abnehmbar ausgebildet ist.

3. Flachbaugruppe nach Anspruch 2, dadurch gekennzeichnet, daß der Längskanal (8) auf der einen Seite von den Schraubanschlüssen (3) und danebenliegenden Lumineszenzdioden (13) flankiert ist, wobei die Beschriftungsplatte (15) im Betriebszustand neben den Lumineszenzdioden (13) liegt.

4. Flachbaugruppe nach Anspruch 3, dadurch gekennzeichnet, daß die Lumineszenzdioden (13) in einem mit der Leiterplatte elektrisch und mechanisch verbundenen Halter (47) angeordnet sind.

5. Flachbaugruppe nach einem der Ansprüche 1 bis 4, dadurch gekennzeichnet, daß von der Frontseite gesehen hinter der Steckeinheit (4) nach Ausschwenken der Steckeinheit (4) von der Frontseite zugängliche Module (46, 45) zur Absicherung und/oder Einstellung von Arbeits- und Meßbereichen in der Flachbaugruppe (1, 2) befestigt sind.

6. Flachbaugruppe nach Anspruch 5, dadurch gekennzeichnet, daß die Module (45, 46) über ihre Seitenwandung mit Schwalbenschwanzverbindung (44) mit der Steckerleiste (35) in Verbindung stehen.

7. Flächbaugruppe nach Anspruch 1, dadurch gekennzeichnet, daß an der dem Schwenkgelenk (39) gegenüberliegenden Seite der Steckeinheit (4) eine axial unverschieblich gelagerte, in ein Gewinde (55) an der Steckerleiste (35) eindrehbare Befestigungsschraube (54) angeordnet ist.

## Claims

1. A box-like electronic printed circuit board module having threaded terminal ends (3) for connection leads (9) formed as a plug-in terminal unit (4) operable from the front, wherein the connection lead inlet openings (11) in the threaded terminal ends (3) open into a longitudinal channel (8) that is open at the front and the terminal unit (4), which is provided with a swivel hinge (39), can make contact with a printed circuit board (6) in the printed circuit board module (1), characterised in that a cover formed as a lettering panel (15) covers the longitudinal channel (8) and the threaded terminal ends (3) at the front of the printed circuit board module, and a plug connector strip (35) adapted to the plug-in terminal unit (14) is electrically and mechanically connected to the printed circuit board (6), and that the plug-in terminal unit (4) is provided with a swivel hinge (39) of which the counterpart is on the plug connector strip (35).

2. A printed circuit board module according to claim 1, characterised in that the longitudinal channel (8) is provided on the plug-in terminal unit (4) and the side wall (41) opposite to the threaded terminal ends (3) is removable.

3. A printed circuit board module according to claim 2, characterised in that the longitudinal channel (8) is flanked on one side by the threaded terminal ends (3) and light-emitting diodes (13) alongside them, the lettering panel (15) being situated, in use, beside the light-emitting diodes (13).

4. A printed circuit board module according to claim 3, characterised in that the light-emitting diodes (13) are arranged in a holder (47) that is electrically and mechanically connected to the printed circuit board.

5. A printed circuit board module according to any one of claims 1 to 4, characterised in that modules (46, 47) for fusing and/or adjustment of operating and measuring ranges are fixed in the printed circuit board module (1, 2) behind the plug-in terminal unit (4) (when viewed from the front) and are accessible after swinging out the plug-in terminal unit (4).

6. A printed circuit module according to claim 5, characterised in that the modules (45, 46) are connected via their side walls to the plug connector strip (35) by dove-tail connections (44).

7. A printed circuit module according to claim 1, characterised in that at the side of the plug-in terminal unit (4) opposite to the swivel hinge (39) a fixing screw (54) that can be screwed into a thread (55) in the plug connector strip (35) is mounted so as not to be axially displaceable.

## Revendications

1. Module électronique plat en forme de boîte (1) comportant des bornes à vis (3), qui peuvent être actionnées frontalement, sont réalisées sous la forme d'une unité enfichable (4) et sont prévues pour des conducteurs de raccordement (9), et dans lequel les ouvertures (11) d'insertion des conducteurs de raccordement, que comportent les bornes à vis (3), débouchent dans un conduit longitudinal (8) qui s'ouvre en direction de la face frontale et dans lequel l'unité enfichable (4) munie d'une articulation pivotante (39) peut établir un contact avec une plaquette à circuits imprimés (6) prévue dans le module plat (1), caractérisé par le fait qu'un revêtement réalisé sous la forme d'une plaque (15) munie d'inscriptions, recouvre le conduit longitudinal (8) et les bornes à vis (3) au niveau de la face avant du module plat (1), qu'une barrette de connexions (35) adaptée à l'unité enfichable (3) est reliée électriquement et mécaniquement à la plaquette à circuits imprimés (6) et que l'unité enfichable (4) est munie d'une articulation pivotante (39), dont la butée d'application est montée sur la barrette de connexions (35).

2. Module plat suivant la revendication 1, caractérisé par le fait que le conduit longitudinal (8) est prévu sur l'unité enfichable (4) et que la paroi latérale (41), située en vis-à-vis des bornes à vis (3), est réalisée de manière à être amovible.

3. Module plat suivant la revendication 2, caractérisé par le fait que le conduit longitudinal (8) est flanqué, d'un côté, par les bornes à vis (3) et par des diodes à luminescence (13) disposées à côté de ces bornes, la plaque (15) munie d'inscriptions étant située, dans l'état de fonctionnement, à côté des diodes à luminescence (15).

4. Module plat suivant la revendication 3, caractérisé par le fait que les diodes à luminescence (13) sont disposées dans un support (47) relié électriquement et mécaniquement à la plaquette à circuits imprimés.

5. Module plat suivant l'une des revendications 1 à 4, caractérisé par le fait qu'en arrière de l'unité enfichable (4), lorsque l'on regarde la face avant, se trouvent fixés des modules (46, 45) accessibles après écartement par basculement de l'unité enfichable (4) à partir de la face avant, et servant à protéger par fusibles et/ou penmettant de régler des plages de travail et de mesure dans le module plat.

6. Module plat suivant la revendication 5, caractérisé par le fait que les modules (45, 46) sont reliés, par l'intermédiaire de leurs parois latérales et selon un système de liaison en queue d'aronde (44), à la barrette de connexions (35).

7. Module plat suivant la revendication 1, caractérisé par le fait que sur le côté de l'unité enfichable (4) situé à l'opposé de l'articulation pivotante (39), se trouve disposée une vis de fixation (54) qui est montée de manière à être bloquée contre tout déplacement axial et peut être vissée dans un taraudage (55) prévu dans la barrette de connexions (35).

FIG 1

0 165 434

FIG 2

FIG 3

FIG 4

FIG 5

FIG 6

0 165 434

FIG 7